Europäisches Patentamt

European Patent Office

Office européen des brevets

(19)

(11) EP 0 678 751 B1

(12) **FASCICULE DE BREVET EUROPEEN**

(45) Date de publication et mention
de la délivrance du brevet:
**18.09.2002 Bulletin 2002/38**

(51) Int Cl.$^7$: **G01R 19/165**

(21) Numéro de dépôt: **95400862.9**

(22) Date de dépôt: **18.04.1995**

(54) **Dispositif de détection de la variation d'une tension d'alimentation**

Detektorvorrichtung für Änderungen einer Versorgungsspannung

Detector for variations of a supply voltage

(84) Etats contractants désignés:
**DE GB IT NL**

(30) Priorité: **22.04.1994 FR 9404875**

(43) Date de publication de la demande:
**25.10.1995 Bulletin 1995/43**

(73) Titulaire: **ATMEL NANTES SA**
**44300 Nantes (FR)**

(72) Inventeurs:
• **Gerber, Rémi**
**F-44300 Nantes (FR)**
• **Silloray, Janick**
**F-44300 Nantes (FR)**

(74) Mandataire: **Fréchède, Michel et al**
**Cabinet Plasseraud**
**84, rue d'Amsterdam**
**F-75440 Paris Cédex 09 (FR)**

(56) Documents cités:
**WO-A-93/06492          DE-A- 3 935 577**

• **RESEARCH DISCLOSURE, no. 325, Mai 1991
EMSWORTH GB, page 356 ANONYMUS 'BULK
SUPPLY SUPERVISORY CIRCUIT'**
• **PROC. ANNUAL INTERNAT. CONF. IEEE
ENGINEERING IN MEDICINE AND BIOLOGY
SOCIETY. PART 3/3 COMPUTERS AND SIGNAL
PROCESSING IN MEDICINE, 7 Novembre 1988
NEW ORLEANS, LOUISIANA, USA, pages
1235-1238, SCHALDACH 'DESIGN AND
RELIABILITY CONSIDERATIONS IN IMPLANTS'**
• **RESEARCH DISCLOSURE, no. 335, Mars 1992
EMSWORTH GB, pages 224-225, ANONYMUS
'CMOS POWER ON DETECTION CIRCUIT'**

**Description**

La présente invention concerne un dispositif de détection de la variation d'une tension d'alimentation électrique.

Dans les systèmes informatiques ou électroniques actuels, la notion d'autonomie de ces systèmes est primordiale. Indépendamment de l'autonomie effective de ces derniers, en particulier lorsqu'ils sont mis en oeuvre sous forme de matériels embarqués portables voire implantés, il est de la plus haute importance de pouvoir contrôler et surveiller l'évolution de la tension d'alimentation électrique de ces appareils, lorsque notamment ceux-ci sont alimentés à partir de batteries d'accumulateurs rechargeables par exemple.

De manière classique, l'homme de l'art sait comparer la valeur d'une tension à surveiller, telle que la valeur de la tension d'une batterie d'accumulateurs, à une valeur de seuil, de manière à engendrer un signal lors du franchissement de cette valeur de seuil par la tension à surveiller. Ce mode opératoire à partir d'un comparateur permet cependant au plus de détecter le seul franchissement de la valeur de seuil, sans donner d'information telle que la nature transitoire ou non de ce franchissement, sauf à prévoir des circuits de filtrage des perturbations transitoires de cette tension à surveiller.

Le document "CMOS Power-on detection circuit", Research Disclosure No. 335, Mars 1992, Emsworth, GB, pages 224 à 225 décrit un détecteur de ce genre.

En outre, en général le déclenchement de ces comparateurs implique un déclenchement soit par valeurs supérieures, soit par valeurs inférieures, la mise en oeuvre de dispositifs de surveillance utilisables tant à l'initialisation ou mise en route de ces appareils qu'en fin de durée de vie de leur batterie d'accumulateurs d'alimentation impliquant en fait le doublement de ces dispositifs par mise en parallèle de ce type de comparateurs, l'un déclenchant sur dépassement par valeurs supérieures, l'autre par valeurs inférieures.

La présente invention a pour objet de remédier aux inconvénients précités des dispositifs de l'art antérieur par la mise en oeuvre d'un dispositif de détection de la variation notamment non transitoire d'une tension d'alimentation permettant de délivrer un signal détecté de valeur constante, tant que la tension d'alimentation est supérieure à une valeur de seuil déterminée, et un signal détecté dont la valeur est égale à celle de la tension d'alimentation, tant que cette dernière est inférieure à ladite valeur de seuil.

Un autre objet de la présente invention est la mise en oeuvre d'un dispositif de détection de la variation notamment non transitoire d'une tension d'alimentation électrique permettant d'effectuer un contrôle et une surveillance du niveau de la tension d'alimentation d'appareils électroniques, micro-électroniques ou informatiques, au prix d'une très faible consommation de l'énergie électrique de cette source d'alimentation.

Le dispositif de détection de la variation d'une tension d'alimentation par rapport à une tension de référence, objet de la présente invention, est remarquable en ce qu'il comprend un circuit détecteur à seuil asymétrique d'une variation de tension comprenant une entrée de référence connectée à la tension de référence, et une entrée de détection alimentée par la tension d'alimentation par l'intermédiaire d'un premier diviseur potentiométrique. Le circuit détecteur à seuil permet de délivrer une tension variable à partir de la tension de référence copie des variations, avec la même pente, de la tension d'alimentation. Un circuit comparateur de niveau est prévu, ce circuit comportant une entrée de comparaison négative et une entrée de comparaison positive. L'entrée de comparaison négative est connectée au circuit détecteur à seuil et reçoit la tension variable et l'entrée de comparaison positive est reliée à la tension d'alimentation par l'intermédiaire d'un deuxième diviseur potentiométrique, ajustable, commandé par la sortie du circuit comparateur de niveau. Le circuit comparateur de niveau engendre sur sa sortie un signal dont la valeur est égale soit à la valeur de la tension d'alimentation, lorsque cette dernière est inférieure ou égale à une valeur de seuil, soit à la valeur de la tension de référence lorsque la tension d'alimentation est supérieure à cette valeur de seuil.

Le dispositif de détection objet de l'invention trouve application dans l'industrie électronique ou microélectronique pour la mise en oeuvre de circuits de contrôle ou de surveillance de la tension d'alimentation de matériels informatiques ou micro-électroniques, portables, implantés ou d'électronique automobile.

Il sera mieux compris à la lecture de la description et à l'observation des dessins ci-après dans lesquels :

- la figure 1 représente, sous forme de blocs fonctionnels, un schéma synoptique du dispositif objet de la présente invention,
- les figures 2a, 2b montrent un chronogramme des variations de tension lors de l'établissement et de la coupure, par exemple, de la tension d'alimentation,
- la figure 3a représente un détail de réalisation du premier pont diviseur permettant de supprimer les variations transitoires de la tension d'alimentation transmises à l'entrée du détecteur à seuil,
- la figure 3b représente un mode de réalisation particulier, non limitatif, du détecteur à seuil en technologie CMOS,
- les figures 4a et 4b représentent différents chronogrammes de signaux aux points de test de la figure 1.

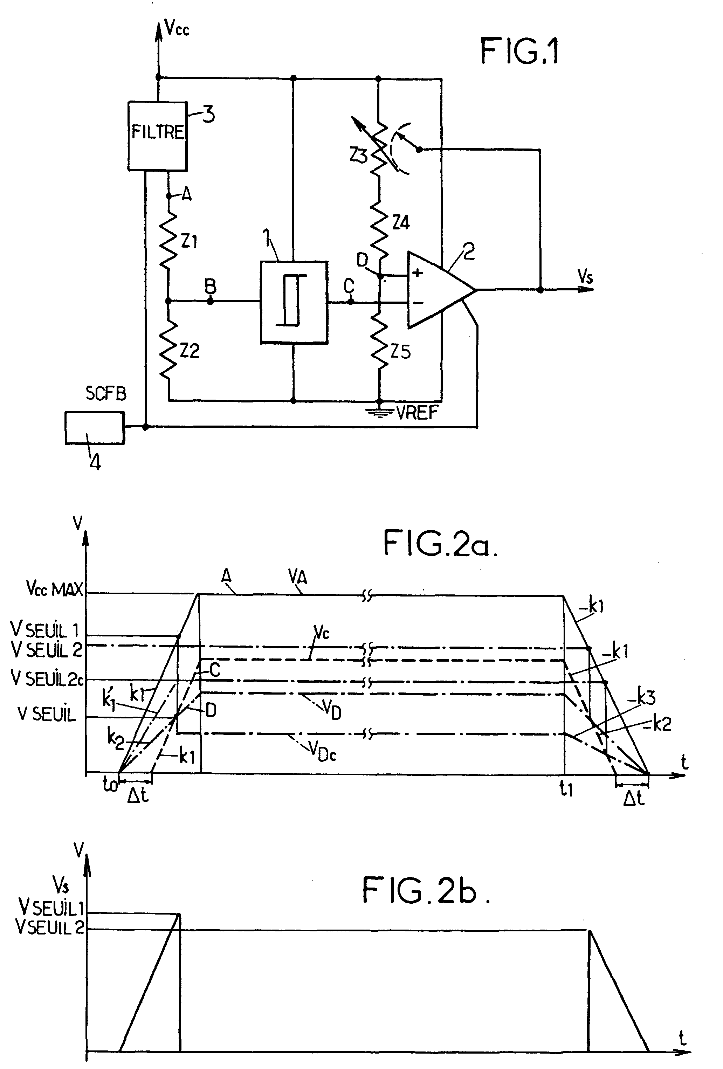

Le dispositif de détection de la variation notamment non transitoire d'une tension d'alimentation électrique, objet de la présente invention, sera maintenant décrit en liaison avec les figures 1 et suivantes.

Selon la figure 1 précitée, on indique que le dispositif objet de la présente invention comprend un circuit 1 détecteur à seuil asymétrique d'une variation de tension, ce circuit permettant, à partir de la tension de référence, notée $V_{REF}$, de délivrer une tension variable, laquelle est une copie des variations, avec la même pente, de la tension d'alimentation notée $V_{CC}$.

La fonction de transfert du circuit détecteur 1 est représentée en figures 2a et 2b, lesquelles seront explicitées ultérieurement dans la description. Le circuit détecteur à seuil 1 comprend une entrée de référence connectée à la tension de référence $V_{REF}$, et une entrée de détection. L'entrée de détection est alimentée par la tension d'alimentation $V_{CC}$ par l'intermédiaire d'un premier diviseur potentiométrique. On indique d'une manière générale que le premier diviseur potentiométrique, ainsi que représenté en figure 2a, délivre à partir de la tension d'alimentation $V_{CC}$ lorsque celle-ci est soumise à des variations, un signal représenté, correspondant au point de test A de la figure 1, cette variation étant représentée entre la tension de référence $V_{REF}$ et la tension d'alimentation $V_{CC}$ avec une pente $k_1$ lors par exemple de la mise sous tension de l'ensemble du dispositif de détection représenté en figure 1, le premier dispositif diviseur potentiométrique délivrant à l'entrée du circuit détecteur 1 une tension correspondante avec une pente de valeur $k'_1$, ainsi que représenté pour le point de test B de la figure 1 en trait mixte sur la figure 2a.

Le circuit détecteur à seuil 1 permet de délivrer, ainsi que représenté en figure 2a, le signal tel que représenté au point de test C de la figure 1, ce signal correspondant à la tension variable, avec la même pente $k_1$ que celle de la variation de la tension d'alimentation avec un retard dû à l'asymétrie du seuil du détecteur, ce retard étant noté $\Delta t$ sur la figure 2a.

En outre, le dispositif de détection objet de la présente invention comprend un circuit comparateur de niveau 2, comportant une entrée de comparaison négative et une entrée de comparaison positive. L'entrée de comparaison négative est connectée en sortie du circuit détecteur à seuil 1 et reçoit la tension variable, tel que représentée en figure 2, alors que l'entrée de comparaison positive du circuit comparateur 2 est reliée à la tension d'alimentation par l'intermédiaire d'un deuxième diviseur potentiométrique ajustable, commandé par la sortie du circuit comparateur de niveau 2.

Le fonctionnement du dispositif de détection représenté en figure 1 est le suivant : pour une variation de la tension d'alimentation $V_{CC}$ à partir d'une valeur de tension de départ sensiblement stable, lors de la mise sous tension à un instant $t_0$ de l'ensemble par exemple à partir d'une valeur zéro correspondant à la tension de référence $V_{REF}$, la tension délivrée au point de test D de la figure 1 correspondant à l'entrée positive du circuit comparateur de niveau 2, évolue avec une pente $k_2$, ainsi que représenté en figure 2a, inférieure à la pente $k_1$ de la tension variable délivrée par le circuit détecteur à seuil 1. En raison du retard $\Delta t$ de la tension variable précitée, mais compte tenu de la pente $k_1$ supérieure à la pente $k_2$ de la tension variable par rapport à la pente du signal délivré par le deuxième diviseur potentiométrique, le signal de sortie Vs délivré par le circuit comparateur de niveau 2 n'est autre que la tension d'alimentation $V_{CC}$, tant que la tension variable délivrée par le circuit détecteur à seuil 1 est inférieure au signal délivré par le deuxième diviseur potentiométrique à l'entrée de comparaison positive du circuit comparateur de niveau 2. Sur dépassement de cette dernière, ainsi que représenté en figure 2, le circuit comparateur de niveau 2 provoque une commutation et la tension de sortie Vs précédemment égale à la tension variable précitée et délivre, sur commutation, une tension constante égale à la tension de référence $V_{REF}$. La commutation se produit pour une valeur de la tension d'alimentation égale à $V_{seuil1}$. Cette variation de la tension de sortie Vs provoque alors une commutation de la valeur du deuxième diviseur potentiométrique précédemment cité, par augmentation de l'impédance totale du deuxième diviseur potentiométrique précité, ce qui permet d'abaisser la valeur de la tension d'entrée appliquée à l'entrée de comparaison positive du circuit comparateur de niveau 2 à une valeur basse, le circuit comparateur de niveau 2 délivrant alors en sortie la tension de sortie Vs dont la valeur est égale à la tension de référence $V_{REF}$ tant que la tension d'alimentation $V_{CC}$ reste supérieure à la nouvelle valeur de seuil, définie par la commutation de la valeur du deuxième diviseur potentiométrique.

D'une manière générale, on indique que lors d'une variation de la tension d'alimentation à partir d'une valeur d'alimentation maximale $V_{CCmax}$ par exemple, ainsi que représenté en figure 2a, le processus est sensiblement symétrique, le deuxième diviseur potentiométrique ayant été ramené à sa valeur initiale.

Sur la figure 2a, on a représenté également une variation de la tension d'alimentation à partir de la valeur maximale $V_{CCmax}$ avec une pente opposée $-k_1$. En l'absence de retour à la valeur initiale du deuxième diviseur potentiométrique, la valeur de la tension au point de test D est par exemple égale à $V_{DC}$, fixée par la valeur commutée du deuxième potentiomètre. En présence d'un retour à la valeur initiale du deuxième diviseur potentiométrique, la valeur de la tension au point de test D est par exemple égale à $V_D$, fixée par la valeur non commutée du deuxième potentiomètre. Sur variation de la tension d'alimentation $V_{CC}$ à partir de la valeur maximale $V_{CCmax}$ à un instant $t_1$ quelconque, la variation étant une diminution avec une pente $-k_1$ pour fixer les idées, la tension variable au point C évolue avec la même pente $-k_1$ à partir de la valeur initiale $V_C$. La tension au point D évolue en outre à partir de la valeur initiale $V_D$ ou $V_{DC}$ en présence ou non d'un retour à la valeur initiale, avec une pente $-k_2$ respectivement $-k_3$ en fonction de la valeur non commutée ou commutée du deuxième diviseur potentiométrique. Ainsi, l'intersection des valeurs de tension $V_C$ au point C et $V_D$ ou $V_{DC}$

au point D Intervient pour une valeur de seuil $V_{seuil2}$ respectivement $V_{seuil2c}$ de la tension d'alimentation. Dans le cas général, les tensions $V_{seuil1}$ et $V_{seuil2}$ sont différentes, car dépendant des valeurs initiales $V_D$, $V_{DC}$.

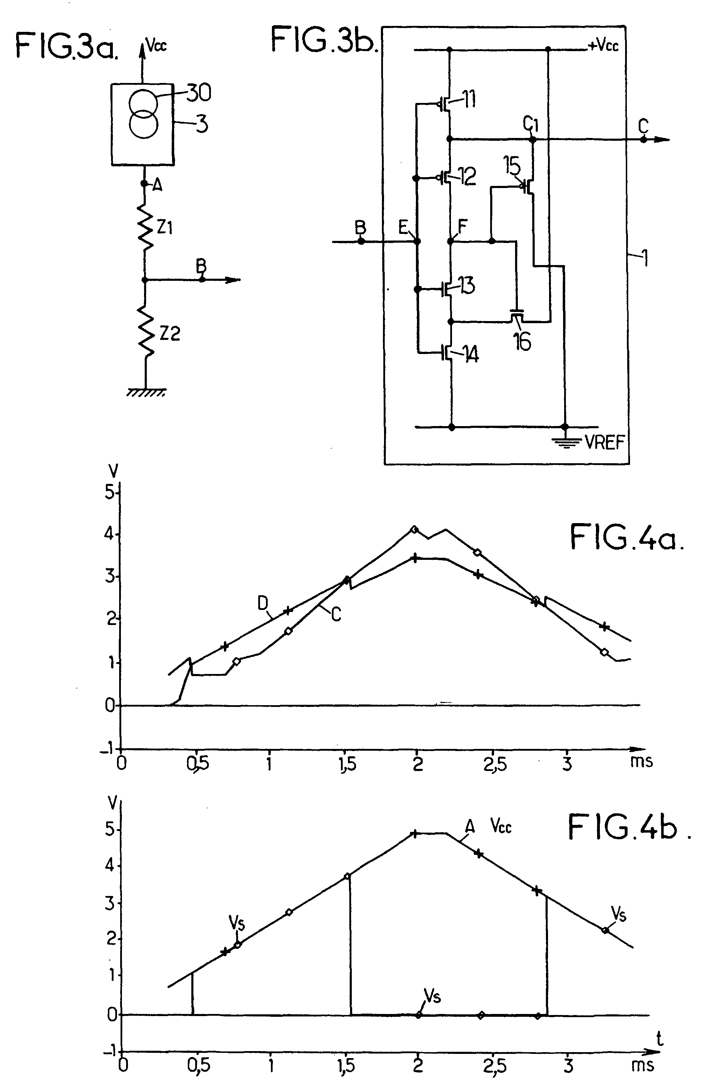

Ainsi qu'on l'a en outre représenté en figure 3a, on indique que le premier diviseur potentiométrique peut comprendre, connecté en cascade entre la tension d'alimentation $V_{CC}$ et la tension de référence $V_{REF}$, un circuit 3 de type à courant constant permettant d'atténuer les variations transitoires de la tension d'alimentation $V_{CC}$ à l'entrée du circuit comparateur de niveau 1. On indique que ce circuit 3 peut être constitué par un générateur de courant, lequel, en raison du courant imposé par ce dernier, impose sensiblement au point de test A de la figure 1 une tension continue sensiblement égale à la tension d'alimentation $V_{CC}$ en ce point.

Au générateur de courant 30 est connecté un réseau de résistances Z1, Z2, le point commun de ces résistances étant relié à l'entrée du circuit détecteur de niveau 1.

En ce qui concerne le deuxième diviseur potentiométrique, on indique que celui-ci peut être formé par, successivement connectées entre la tension d'alimentation $V_{CC}$ et la tension de référence $V_{REF}$, une impédance ajustable programmable Z3, une résistance Z4 et une résistance Z5, les impédances ou résistances Z3 à Z5 étant connectées entre la tension d'alimentation et la tension de référence $V_{REF}$, le point commun entre la résistance Z4 et la résistance Z5 étant relié à l'entrée de comparaison positive du circuit comparateur de niveau 2.

En ce qui concerne la valeur des résistances Z3, Z4, Z5 du deuxième diviseur potentiométrique, on indique que ces valeurs sont choisies de façon à constituer, pour la tension appliquée au point de test D de la figure 1 une valeur de seuil, notée $V_{seuil}$, correspondant à l'initialisation à une valeur arbitraire fraction de la tension d'alimentation maximale $V_{CCmax}$ précédemment indiquée dans la description. On indique que pour une tension d'alimentation $V_{CCmax}$ égale à 5 volts, la valeur de seuil ainsi constituée initialement peut être prise égale à $V_{seuil}$ = 2 volts.

Lors de la commutation par l'intermédiaire de la tension de sortie Vs, on indique que l'impédance Z3 est amenée à une valeur plus importante que la valeur initiale précitée, cette valeur de Z3 étant choisie de façon que, après commutation par l'intermédiaire de la tension de sortie Vs, la tension au point de test D délivrée par le deuxième diviseur potentiométrique soit inférieure à la tension délivrée sur l'entrée de comparaison négative du circuit comparateur de niveau 2, soit à la valeur d'intersection des courbes de pente $k_1$ et $k_2$ sur la figure 2.

La figure 2b montre le chronogramme correspondant de la tension de sortie Vs délivrée par la sortie du comparateur de niveau 2.

Une description plus détaillée du circuit détecteur à seuil 1 sera maintenant donnée en liaison avec la figure 3b.

Dans le mode de réalisation précité, on indique que le circuit détecteur à seuil 1 peut comprendre avantageusement un premier, un deuxième, un troisième et un quatrième transistor MOS, référencés 11, 12, 13, 14 respectivement, connectés en série entre la tension d'alimentation $V_{CC}$ et la tension de référence $V_{REF}$. Les premier et deuxième transistors MOS 11 et 12 sont d'un même premier type de conduction, type P dans le cas de la représentation de la figure 3b, et les troisième et quatrième transistors MOS 13 et 14 sont d'un deuxième type de conduction, opposé au premier type, et donc de type N dans le cas de la représentation de la figure 3b.

Le premier pont diviseur, tel que représenté par exemple en figure 3a, est alors connecté en parallèle à partir du point commun entre les impédances Z1 et Z2 à la grille du premier, deuxième, troisième et quatrième transistors MOS 11, 12, 13 et 14.

En outre, un cinquième transistor MOS, noté 15, de même type de conduction que le premier type de conduction, de type P, est prévu, l'électrode de grille du cinquième transistor MOS 15 étant reliée au point commun entre le deuxième et le troisième transistor MOS 12, 13 précédemment mentionnés. Les électrodes de source et de drain du cinquième transistor MOS 15 sont connectées entre le point commun du premier et du deuxième transistor MOS 11, 12 et la tension de référence $V_{REF}$.

On indique que, à l'état de conduction, le cinquième transistor MOS 15 présente une résistance très supérieure à celle du premier transistor MOS 11 dans un rapport 1 000 environ.

Enfin, un sixième transistor MOS 16, de même type de conduction que le deuxième type de conduction précédemment cité, soit un sixième transistor MOS 16 de type N, est prévu, l'électrode de grille de ce transistor étant reliée au point commun entre le deuxième et le troisième transistor MOS 12, 13. Les électrodes de drain et de source du sixième transistor MOS 16 sont connectées entre la tension d'alimentation $V_{CC}$ et le point commun entre le troisième et le quatrième transistor MOS 13, 14 précédemment mentionnés.

Sur la figure 3b, on a indiqué la présence de points de test E, lesquels correspondent respectivement aux points de test B de la figure 1, au point commun entre le deuxième et le troisième transistor MOS 12, 13, c'est-à-dire à la grille du cinquième transistor MOS 15, et au point commun entre le premier et le deuxième transistor MOS 11, 12 ainsi qu'aux points de test C de la figure 1, c'est-à-dire en sortie du circuit détecteur à seuil 1 de la figure 1.

Le fonctionnement de ce dernier circuit tel que représenté en figure 3b est le suivant, dans le cas où, lors de l'initialisation, la tension d'alimentation est portée de la valeur zéro à la valeur $V_{CCmax}$ avec une constante de temps déterminée, la constante de temps correspondant à la pente $k_1$ sur la figure 1.

Les points de test E et F sont tout d'abord à la valeur zéro. Pendant la montée de la tension d'alimentation vers la valeur $V_{CCmax}$ avec la pente $k_1$, la tension au point de test G, c'est-à-dire en sortie du circuit détecteur à seuil, se maintient à la valeur de la tension de référence $V_{REF}$. Il en est de même pour le point de test F en raison de l'absence de conduction des premier, deuxième, troisième et quatrième transistors MOS 11 à 14.

La tension d'alimentation augmentant avec la pente $k_1$, la tension au point de test E augmente également et les premier, deuxième, troisième transistors MOS 11, 12 et 13 se mettent alors à conduire, la tension au point de test G, c'est-à-dire en sortie du circuit détecteur à seuil 1 prenant la valeur :

$$V^- = \frac{ZT5}{ZT5 + ZT1}V_{CC} \simeq V_{CC}.$$

En raison du rapport des impédances de 1 à 1000 entre les premier et cinquième transistor MOS 11 et 15, on comprend que la tension délivrée par le point G, c'est-à-dire par la sortie du circuit détecteur à seuil, suit ainsi la pente de la valeur de la tension d'alimentation $V_{CC}$ avec la valeur de seuil ou de retard $\Delta t$ précédemment mentionnée dans la description.

On comprend également que pour une variation négative de la tension à partir d'une valeur finale correspondant à la tension d'alimentation $V_{CCmax}$, la tension variable délivrée par le circuit détecteur à seuil 1 suit également la pente de cette tension d'alimentation variable en raison de la valeur des impédances précitées.

On comprend ainsi que lors de la conduction des cinquième et premier transistors MOS 15 et 11, le point commun des premier et deuxième transistors MOS 11 et 12 permet de délivrer une tension proportionnelle à la tension d'alimentation, laquelle constitue la tension variable délivrée par le circuit détecteur 1.

D'une manière générale, dans un mode préférentiel de réalisation, on indique que le circuit d'atténuation des variations transitoires de la tension d'alimentation $V_{CC}$, le circuit 3, et plus spécifiquement le générateur de courant 30, peuvent être réalisés en technologie CMOS, ce qui permet bien sûr, à partir d'une réalisation telle que représentée en figure 3b pour le circuit détecteur à seuil 1 et pour le circuit comparateur de niveau 2, d'envisager la réalisation du dispositif de détection objet de la présente invention sous forme de circuit intégré. On indique d'autre part que les impédances Z1 à Z5 peuvent également être réalisées au moyen de transistors de type MOS, lesquels peuvent permettre la réalisation de résistances de bonne précision. En ce qui concerne plus particulièrement l'impédance ajustable Z3, on indique que celle-ci peut être réalisée sous forme d'impédances programmables au moyen de circuits MOS afin de permettre également l'intégration de l'ensemble. Les valeurs finales $V_D$, $V_{DC}$ et de seuil $V_{seuil1}$, $V_{seuil2}$, $V_{seuil2c}$ peuvent ainsi être ajustées.

Ainsi qu'on l'a également représenté en figure 1, le dispositif de détection objet de la présente invention, peut comprendre avantageusement un circuit 4 de commande permettant de délivrer un signal de mise en service ou de blocage, ce signal étant noté SCFB sur la figure 1 précitée. Ce signal de mise en fonctionnement ou de blocage permet par exemple d'assurer la mise en service ou le blocage du générateur de courant 3 et du comparateur de niveau 2, ce qui permet de commander le fonctionnement ou l'arrêt de l'ensemble du dispositif de détection par blocage ou mise en fonctionnement des circuits détecteur à seuil 1, comparateur de niveau 2 et générateur de courant 3.

D'une manière générale, on indique que le circuit de commande 4 peut simplement délivrer un signal bloquant ou autorisant l'alimentation du circuit de filtrage 3 et du circuit comparateur de niveau 2, par exemple.

Dans un mode de réalisation plus avantageux, on indique que le circuit de commande 4 peut délivrer un signal périodique, lequel permet d'effectuer une commande échantillonnée du fonctionnement du dispositif, afin d'obtenir une réduction de la consommation globale d'énergie du dispositif représenté en figure 1.

D'une manière générale, on indique que la période et la durée d'échantillonnage sont programmables et modulables en fonction de l'application considérée. Ainsi, lorsque le dispositif de détection objet de la présente invention, est utilisé pour contrôler et surveiller la tension d'alimentation d'un micro-ordinateur portable par exemple, la période d'échantillonnage peut être fixée par exemple à une valeur de dix minutes, la durée d'échantillonnage elle-même étant par exemple de quelques centaines de ms.

Lorsque, au contraire, le dispositif de détection objet de la présente invention est appliqué au contrôle et à la surveillance de la tension d'alimentation d'un véhicule automobile par exemple, la période d'échantillonnage peut être portée à une durée beaucoup plus grande, une à plusieurs heures par exemple.

Enfin, dans le cas de matériels électroniques implantés, tels que des simulateurs cardiaques, on indique que la période d'échantillonnage peut être ramenée si nécessaire à quelques minutes afin d'assurer une surveillance constante de la tension d'alimentation de ces simulateurs.

Les figures 4a et 4b représentent l'allure des variations de tension au point de test C et D de la figure 1 respectivement d'une tension d'alimentation variable et de la tension de sortie Vs correspondante.

On a ainsi décrit un dispositif de détection de la variation notamment non transitoire d'une tension d'alimentation particulièrement performant dans la mesure où ce dispositif permet de délivrer soit une tension égale à la tension d'alimentation lorsque celle-ci est inférieure à une valeur de seuil et une tension constante égale à la tension de référence ou masse lorsqu'au contraire, la tension d'alimentation est supérieure à la valeur de seuil précitée. Ce dispositif présente une très grande souplesse d'utilisation dans la mesure où le fonctionnement de ce dernier peut être commandé soit manuellement, soit de manière automatique selon un mode échantillonné.

**Revendications**

1. Dispositif de détection de la variation d'une tension d'alimentation ($V_{CC}$), par rapport à une tension de référence, ($V_{REF}$) comprenant:

   - un circuit détecteur (1) à seuil asymétrique d'une variation de tension, ce circuit détecteur (1) à seuil comportant une entrée de référence connectée à la tension de référence ($V_{REF}$) et une entrée de détection alimentée par ladite tension d'alimentation ($V_{CC}$) par l'intermédiaire d'un premier diviseur potentiométrique ($Z_1$, $Z_2$, 3) ce circuit détecteur (1) à seuil permettant, à partir de la tension de référence, $V_{REF}$ de délivrer une tension variable, copie des variations, avec la même pente, de la tension d'alimentation ($V_{CC}$),
   - un circuit comparateur de niveau (2) comportant une entrée de comparaison négative et une entrée de comparaison positive, ladite entrée de comparaison négative étant connectée audit circuit détecteur (1) à seuil et recevant ladite tension variable et ladite entrée de comparaison positive étant reliée à ladite tension d'alimentation ($V_{CC}$) par l'intermédiaire d'un deuxième diviseur potentiométrique, ($Z_3$, $Z_4$, $Z_5$) ajustable, commandé par la sortie dudit circuit comparateur de niveau (2), ce qui permet d'engendrer en sortie dudit comparateur de niveau (2) un signal ($V_S$) dont la valeur est égale soit à la valeur de la tension d'alimentation ($V_{CC}$) lorsque ladite tension d'alimentation est inférieure ou égale à une valeur de seuil, soit à la valeur de la tension de référence ($V_{REF}$) lorsque ladite tension d'alimentation est supérieure à ladite valeur de seuil.

2. Dispositif selon la revendication 1, **caractérisé en ce que** le premier diviseur potentiométrique ($Z_1$, $Z_2$, 3) est agencé pour atténuer les variations transitoires de la tension d'alimentation ($V_{CC}$), et **en ce que** le circuit détecteur (1) à seuil est capable de détecter des variations non transitoires de ladite tension d'alimentation ($V_{CC}$).

3. Dispositif selon la revendication 2, **caractérisé en ce que** ledit premier diviseur potentiométrique ($Z_1$, $Z_2$, 3) comprend, connectés en cascade entre la tension d'alimentation et la tension de référence:

   - un générateur de courant (3),

   - un réseau de résistances ($Z_1$, $Z_2$) le point milieu des résistances étant relié à l'entrée dudit circuit détecteur (1) à seuil.

4. Dispositif selon l'une des revendications 1 à 3, **caractérisé en ce que** ledit circuit détecteur (1) à seuil comprend:

   - un premier (11), deuxième (12), troisième (13) et quatrième (14) transistors MOS connectés successivement en série entre ladite tension d'alimentation ($V_{CC}$) et ladite tension de référence ($V_{REF}$), lesdits premier (11) et deuxième (12) transistors MOS étant d'un même premier type de conduction et lesdits troisième (13) et quatrième (14) transistors MOS étant d'un même deuxième type de conduction, opposé au premier type, ledit premier diviseur potentiométrique ($Z_1$, $Z_2$, 3) etant connecté en parallèle à la grille du premier, deuxième, troisième et quatrième transistors MOS,
   - un cinquième transistor MOS (15) de même type de conduction que le premier type de conduction dont l'électrode de grille est reliée au point commun (F) entre le deuxième (12) et le troisième (13) transistor MOS et dont les électrodes de source et de drain sont connectées entre le point commun ($C_1$) du premier (11) et du deuxième (12) transistor MOS et la tension de référence $V_{REF}$, ledit cinquième transistor MOS (15) présentant en conduction une résistance très supérieure à celle du premier transistor MOS (11),
   - un sixième transistor MOS (16) de même type de conduction que le deuxième type de conduction dont l'électrode de grille est reliée au point commun entre le deuxième (12) et le troisième (13) transistor MOS et dont les électrodes de drain et de source sont connectées entre la tension d'alimentation ($V_{CC}$) et le point commun entre le troisième (13) et le quatrième (14) transistor MOS, ce qui permet lors de la conduction des cinquième (15) et premier (11) transistors MOS de délivrer au point commun ($C_1$) des premier et deuxième transistors MOS une tension proportionnelle à la tension d'alimentation ($V_{CC}$), cette tension proportionnelle constituant ladite tension variable délivrée par le circuit détecteur (1) à seuil.

5. Dispositif selon l'une des revendications précédentes, **caractérisé en ce que** ledit deuxième diviseur potentiométrique ($Z_3$, $Z_4$, $Z_5$) comprend une résistance ajustable ($Z_3$) de valeur programmable ce qui permet d'ajuster ladite valeur de seuil déterminant la valeur du signal par ledit circuit comparateur de niveau (2).

**6.** Dispositif selon l'une des revendications 3 à 5. **caractérisé en ce que** celui-ci comporte en outre un circuit de commande (4) permettant de délivrer un signal de mise en service ou de blocage du générateur de courant et du comparateur de niveau (2), ce qui permet de commander le fonctionnement ou l'arrêt dudit dispositif de détection.

**7.** Dispositif selon la revendication 6, **caractérisé en ce que** ledit circuit de commande (4) délivre un signal périodique, ce qui permet d'effectuer une commande échantillonnée du fonctionnement du dispositif et d'obtenir une réduction de la consommation globale d'énergie.

**8.** Dispositif selon la revendication 6, **caractérisé en ce que** ladite période et la durée d'échantillonnage sont programmables et modulables en fonction de l'application considérée.

**9.** Utilisation d'un dispositif de détection de la variation d'une tension d'alimentation selon l'une des revendications précédentes, à la surveillance et au contrôle de la valeur de la tension de la batterie d'accumulateurs d'un véhicule automobile, d'un micro-ordinateur portable, d'un stimulateur cardiaque ou de batteries d'alimentation électrique d'installations de sécurité.

**Claims**

**1.** Device for detection of the variation of a supply voltage ($V_{CC}$) in relation to a reference voltage ($V_{REF}$) comprising:

- an asymmetric threshold detector circuit (1) for a variation in voltage, this threshold detector circuit (1) comprising a reference input connected to the reference voltage ($V_{REF}$) and a detection input supplied by said supply voltage ($V_{CC}$) through the intermediary of a first potentiometric divider ($Z_1$, $Z_2$, 3), this threshold detector circuit (1) permitting the delivery of a variable voltage, copying the variations, with the same gradient, of the supply voltage ($V_{CC}$) from the reference voltage ($V_{REF}$),
- a level comparator circuit (2) comprising a negative comparison input and a positive comparison input, said negative comparison input being connected to said threshold detector circuit (1) and receiving said variable voltage, and said positive comparison input being connected to said supply voltage ($V_{CC}$) through the intermediary of a second potentiometric divider ($Z_3$, $Z_4$, $Z_5$) which is adjustable and controlled by the output of said level comparator circuit (2), which permits the production at the output of said level comparator (2) of a signal ($V_S$) the value of which is equal either to the value of the supply voltage ($V_{CC}$) when said supply voltage is less than or equal to a threshold value, or to the value of the reference voltage ($V_{REF}$) when said supply voltage is greater than said threshold value.

**2.** Device according to claim 1, **characterised in that** the first potentiometric divider ($Z_1$, $Z_2$, 3) is arranged to attenuate the transient variations of the supply voltage ($V_{CC}$), and **in that** the threshold detector circuit (1) is capable of detecting non-transient variations of said supply voltage ($V_{CC}$).

**3.** Device according to claim 2, **characterised in that** said first potentiometric divider ($Z_1$, $Z_2$, 3) comprises, connected in cascade between the supply voltage and the reference voltage:

- a current generator (3),
- a network of resistors ($Z_1$, $Z_2$), the mid-point of the resistors being connected to the input of said threshold detector circuit (1).

**4.** Device according to one of claims 1 to 3, **characterised in that** said threshold detector circuit (1) comprises:

- a first, second, third and fourth MOS transistor (11, 12, 13 and 14 respectively) successively connected in series between said supply voltage ($V_{CC}$) and said reference voltage ($V_{REF}$), said first and second MOS transistors (11, 12) being of a first conduction type and said third and fourth MOS transistors (13, 14) being of a same second conduction type, the opposite of the first type, said first potentiometric divider ($Z_1$, $Z_2$, 3) being connected in parallel to the gate of the first, second, third and fourth MOS transistors,
- a fifth MOS transistor (15) of the same conduction type as the first conduction type, the gate electrode of which is connected to the common point (F) between the second and the third MOS transistor (12, 13) and the source and drain electrodes of which are connected between the common point ($C_1$) of the first and the second MOS transistors (11, 12) and the reference voltage ($V_{REF}$), said fifth MOS transistor (15) exhibiting a much higher resistance than that of the first MOS transistor (11) when conducting,
- a sixth MOS transistor (16) of the same conduction type as the second conduction type, the gate electrode of which is connected to the common point between the second and the third MOS transistor (12, 13) and the drain and source electrodes of which are connected between the supply voltage ($V_{CC}$) and the common point between the third and the fourth MOS transistor (13, 14), which, when the fifth and first MOS transistors (15, 11) are conducting, permits delivery at the common point ($C_1$) of the first and second MOS transistors of a voltage proportional to the supply voltage ($V_{CC}$), this proportional voltage constituting said variable voltage delivered by the threshold detector circuit (1).

5. Device according to one of the preceding claims, **characterised in that** said second potentiometric divider ($Z_3$, $Z_4$, $Z_5$) comprises an adjustable resistor ($Z_3$) of programmable value, which permits adjustment of said threshold value determining the value of the signal through said level comparator circuit (2).

6. Device according to one of claims 3 to 5, **characterised in that** it additionally comprises a control circuit (4) permitting delivery of a signal for actuating or de-actuating the current generator and the level comparator (2), which allows control of the operation or shut-down of said detection device.

7. Device according to claim 6, **characterised in that** said control circuit (4) delivers a periodic signal, which allows sampled control of the operation of the device and reduction of the overall energy consumption.

8. Device according to claim 6, **characterised in that** said period and the sampling time are programmable and variable as a function of the application concerned.

9. Use of a device for detection of the variation of a supply voltage according to one of the preceding claims, for supervision and control of the value of the voltage of the battery of accumulators of a motor vehicle, of a portable microcomputer, of a heart pacemaker or of batteries supplying electric power for security installations.

**Patentansprüche**

1. Vorrichtung zur Detektion der Änderung einer Versorgungsspannung ($V_{CC}$) in bezug auf eine Bezugsspannung ($V_{REF}$), umfassend:

   - eine asymmetrische Schwellenwert-Detektorschaltung (1) einer Spannungsänderung, wobei diese Schwellenwert-Detektorschaltung einen Bezugseingang, der mit der Bezugsspannung ($V_{REF}$) verbunden ist, und einen Detektionseingang enthält, der durch die Versorgungsspannung ($V_{CC}$) über einen ersten potentiometrischen Teiler ($Z_1$, $Z_2$, 3) gespeist wird, wobei es diese Schwellenwert-Detektorschaltung (1) ermöglicht, ausgehend von der Bezugsspannung ($V_{REF}$), eine veränderliche Spannung zu liefern, die ein Abbild der Änderungen mit der gleichen Steigung der Versorgungsspannung ($V_{CC}$) ist,

   - eine Pegelvergleicherschaltung (2), die einen negativen Vergleichseingang und einen positiven Vergleichseingang enthält, wobei der negative Vergleichseingang mit der Schwellenwert-Detektorschaltung (1) verbunden ist und die veränderliche Spannung empfängt und der positive Vergleichseingang mit der Versorgungsspannung ($V_{CC}$) über einen zweiten potentiometrischen Teiler ($Z_3$, $Z_4$, $Z_5$) verbunden ist, der einstellbar ist und durch den Ausgang der Pegelvergleicherschaltung (2) gesteuert wird, was es ermöglicht, am Ausgang des Pegelvergleichers (2) ein Signal ($V_S$) zu erzeugen, dessen Wert entweder gleich dem Wert der Versorgungsspannung ($V_{CC}$) ist, wenn die Versorgungsspannung kleiner oder gleich einem Schwellenwert ist, oder gleich dem Wert der Bezugsspannung ($V_{REF}$) ist, wenn die Versorgungsspannung größer als der genannte Schwellenwert ist.

2. Vorrichtung nach Anspruch 1, **dadurch gekennzeichnet, daß** der erste potentiometrische Teiler ($Z_1$, $Z_2$, 3) zum Reduzieren der vorübergehenden Änderungen der Versorgungsspannung ($V_{CC}$) ausgelegt ist und daß die Schwellenwert-Detektorschaltung (1) dazu fähig ist, die nicht vorübergehenden Änderungen der Versorgungsspannungen ($V_{CC}$) zu detektieren.

3. Vorrichtung nach Anspruch 2, **dadurch gekennzeichnet, daß** der erste potentiometrische Teiler ($Z_1$, $Z_2$, 3) in Kaskadenschaltung zwischen der Versorgungsspannung und der Bezugsspannung umfaßt:

   - einen Stromerzeuger (3),
   - ein Widerstandsnetzwerk ($Z_1$, $Z_2$), wobei der Mittelpunkt der Widerstände an den Eingang der Schwellenwert-Detektorschaltung (1) angeschlossen ist.

4. Vorrichtung nach einem der Ansprüche 1 bis 3, **dadurch gekennzeichnet, daß** die Schwellenwert-Detektorschaltung (1) umfaßt:

   - einen ersten (11), zweiten (12), dritten (13) und vierten (14) MOS-Transistor, die aufeinanderfolgend zwischen der Versorgungsspannung

($V_{CC}$) und der Bezugsspannung ($V_{REF}$) in Reihe geschaltet sind, wobei der erste (11) und zweite (12) MOS-Transistor von einer gleichen ersten Leitungsart sind und der dritte (13) und vierte (14) MOS-Transistor von einer gleichen zweiten Leitungsart sind, die entgegengesetzt zur ersten Art ist, wobei der erste potentiometrische Teiler ($Z_1$, $Z_2$, 3) parallel an das Gate des ersten, zweiten, dritten und vierten MOS-Transistors angeschlossen ist,

- einen fünften MOS-Transistor (15) von gleicher Leitungsart wie die erste Leitungsart, dessen Gate-Elektrode an den gemeinsamen Anschlußpunkt (F) zwischen dem zweiten (12) und dem dritten (13) MOS-Transistor angeschlossen ist und dessen Source- und Drain-Elektrode zwischen dem gemeinsamen Anschlußpunkt ($C_1$) des ersten (11) und zweiten (12) MOS-Transistors und der Bezugsspannung ($V_{REF}$) angeschlossen sind, wobei der fünfte MOS-Transistor (15) bei Durchgang einen Widerstand aufweist, der viel höher als derjenige des ersten MOS-Transistors (11) ist,

- einen sechsten MOS-Transistor (16) von gleicher Leitungsart wie die zweite Leitungsart, dessen Gate-Elektrode an den gemeinsamen Anschlußpunkt zwischen dem zweiten (12) und dem dritten (13) MOS-Transistor angeschlossen ist und dessen Drain- und Source-Elektrode zwischen der Versorgungsspannung ($V_{CC}$) und dem gemeinsamen Anschlußpunkt zwischen dem dritten (13) und dem vierten (14) MOS-Transistor angeschlossen sind, was es bei Durchgang des fünften (15) und ersten (11) MOS-Transistors ermöglicht, am gemeinsamen Anschlußpunkt ($C_1$) des ersten und zweiten MOS-Transistors eine zur Versorgungsspannung ($V_{CC}$) proportionale Spannung abzugeben, wobei diese proportionale Spannung die von der Schwellenwert-Detektorschaltung (1) abgegebene, veränderliche Spannung bildet.

5. Vorrichtung nach einem der vorhergehenden Ansprüche, **dadurch gekennzeichnet, daß** der zweite potentiometrische Teiler ($Z_3$, $Z_4$, $Z_5$) einen einstellbaren Widerstand ($Z_3$) mit programmierbarem Wert umfaßt, was es ermöglicht, den den Signalwert bestimmenden Schwellenwert durch die Pegelvergleicherschaltung (2) einzustellen.

6. Vorrichtung nach einem der Ansprüche 3 bis 5, **dadurch gekennzeichnet, daß** diese außerdem eine Steuerschaltung (4) enthält, die es ermöglicht, ein Signal zur Inbetriebsetzung oder Sperrung des Stromerzeugers und des Pegelvergleichers (2) abzugeben, was es ermöglicht, den Betrieb oder das Abstellen der genannten Vorrichtung zur Detektion zu steuern.

7. Vorrichtung nach Anspruch 6, **dadurch gekennzeichnet, daß** die Steuerschaltung (4) ein periodisches Signal abgibt, was es ermöglicht, eine Steuerung des Betriebes der Vorrichtung mit Abtastproben zu bewirken und eine Verringerung des Gesamtenergieverbrauchs zu erreichen.

8. Vorrichtung nach Anspruch 7, **dadurch gekennzeichnet, daß** die genannte Periode und die Abtastungsdauer programmierbar und in Abhängigkeit von der betrachteten Anwendung variierbar sind.

9. Verwendung einer Vorrichtung zur Detektion der Änderung einer Versorgungsspannung nach einem der vorhergehenden Ansprüche bei der Überwachung und Kontrolle des Spannungswertes der Akkumulatorenbatterie eines Automobilfahrzeuges, eines tragbaren Mikrocomputers, eines Herzschrittmachers oder der elektrischen Versorgungsbatterien von Sicherheitseinrichtungen.

# FIG.1

# FIG.2a.

# FIG.2b.

FIG.3a.

FIG.3b.

FIG.4a.

FIG.4b.